# EUROPEAN PATENT SPECIFICATION

(11) **EP 0 872 285 B1**
(45) Date of publication and mention of the grant of the patent: **28.03.2007**
(21) Application number: 98302976.0
(22) Date of filing: 17.04.1998
(51) Int. Cl.: B06B 1/06

(54) **Connective backing block for composite transducer**
Leitendes Rückelement für einen zusammengesetzten Wandler
Elément arrière conductif pour und transducteur composite

(30) Priority: 18.04.1997 US 840470
(43) Date of publication of application: 21.10.1998
(73) Proprietor: ADVANCED TECHNOLOGY LABORATORIES, INC., Bothell, Washington 98021 (US)
(72) Inventor: Gilmore, James Michael, Bothell, WA 98011 (US)
(74) Representative: van Oudheusden-Perset, Laure E.

(56) References cited:
- EP-A- 0 426 099
- EP-A- 0 629 993
- US-A- 4 692 654
- US-A- 4 747 192
- US-A- 4 825 115
- US-A- 4 894 895
- US-A- 5 164 920
- US-A- 5 423 220
- PATENT ABSTRACTS OF JAPAN vol. 005, no. 198 (E-087), 16 December 1981 (1981-12-16) & JP 56 120291 A (FURUNO ELECTRIC CO LTD), 21 September 1981 (1981-09-21)

## Description

This invention relates to ultrasonic transducers, and in particular to composite transducer arrays and acoustic backing blocks with integral conductors for a transducer array.

An ultrasonic transducer probe is used by an ultrasound system as the means of transmitting acoustic energy into the subject being examined, and receiving acoustic echoes returning from the subject which are converted into electrical signals for processing and display. Transducer probes may use either single element or multi-element piezoelectric components as the sound transmission and/or reception devices. A multi-element ultrasonic transducer array is generally formed from a bar or block of piezoelectric material, which may be either a ceramic or a polymer. The bar or block is cut or diced into one or more rows of individual elements to form the array. The element-to-element spacing is known as the "pitch" of the array and the spaces between individual elements are known as "kerfs." The kerfs may be filled with some filler material, generally a damping material having low acoustic impedance that blocks and absorbs the transmission of vibrations between adjoining elements, or they may be air-filled. The array of elements may be left in a linear configuration in which all of the elements are in a single plane, or the array may be bent or curved for use as a convex or concave array.

Before the piezoelectric material is diced into individual array elements it is generally coated with metallic electrode material on the top (also referred to as the front, or transmit/receive side) and bottom of the bar. The electrodes on the top of the elements are conventionally connected to an electrical reference potential or ground, and individual conductors are attached to electrode areas on the bottom of the bar to electrically connect to each subsequently formed element. These conductors are then conventionally potted in an acoustic backing material as described, for example, in U.S. Pats. 4,825,115 (Kawabe et al.) which fills the space below the transducer elements and between the wires, and damps acoustic vibrations emanating from the bottom of the transducer array. Alternately, the conductors and backing material may be preformed in a block of backing material containing parallel spaced wires which is then attached to the piezoelectric as described in U.S. Pats. 5,329,498 (Greenstein) and 5,267,221 (Miller et al.). The piezoelectric bar and electrodes are then diced while attached to the backing material. As the bar is diced into individual elements the metal plating is simultaneously cut into individual electrically separate electrodes for each transducer element.

These techniques for forming a transducer array with its electrical connections and backing present various drawbacks in their implementation. The technique described by Kawabe et al. requires that conductors be cut, folded and cast in backing material, all while attached to the transducer ceramic, posing a heightened risk of damaging the ceramic during any of these processing steps. Greenstein and Miller et al. avert this risk by precasting a backing block with embedded conductors oriented in precise alignment with the transducer elements, but provide no guidance on forming such a finely drawn structure easily or inexpensively. Accordingly, it is desirable to be able to fabricate an array transducer easily and inexpensively without a substantial hazard to the transducer ceramic.

In accordance with the principles of the present invention, there is provided a backing block for attachment to an ultrasonic array transducer as claimed in claim 1.

In the drawings:
FIGURE 1 illustrates a monolithic connective backing block of the present invention;
FIGURE 2 illustrates the flexible circuit board of the backing block of FIGURE 1;
FIGURE 3 is a plan view of the distal surface of the backing block of FIGURE 1;
FIGURE 4 illustrates a connective backing block of the present invention suitable for use with a two dimensional transducer array;
FIGURES 5a and 5b are two views of a backing block of a preferred embodiment of the present invention;
FIGURES 6a and 6b are two views of the backing block of FIGURES 5a and 5b when attached to a convex transducer array;
FIGURES 7a and 7b are top plan and side views of a 1-3 composite piezoelectric array of the prior art;
FIGURES 8 and 9 are top plan views of a 1-3 composite piezoelectric array of the present invention;
FIGURES 10a and 10b illustrate two 2-2 composite piezoelectric array elements of the prior art;
FIGURES 11a, 11b, 11c, and 12 illustrate 2-2 composite piezoelectric array elements of the present invention; and
FIGURES 13a-13d illustrate a transducer array of the present invention during various stages of its assembly.

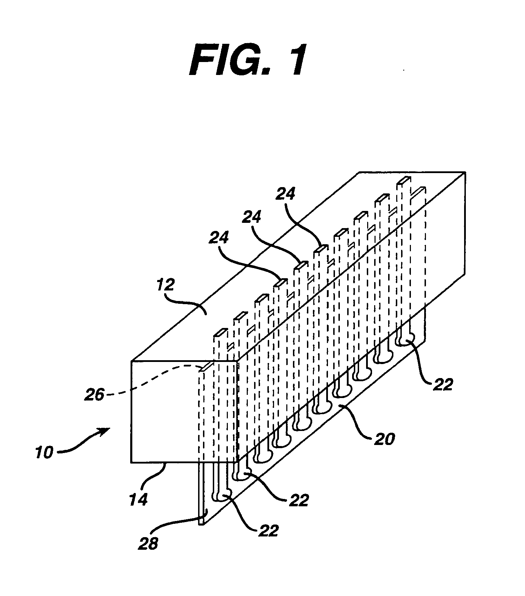

Referring first to FIGURE 1, a monolithic connective backing block 10 for a transducer array constructed in accordance with the principles of the present invention is shown. The backing block is formed of a material with relatively low acoustic impedance and high acoustic attenuation. A suitable material is a filled epoxy or urethane composite. The fillers may be metallic particles such as tungsten or silver, oxide powders, or microballoons. The filler may be blended with the epoxy or urethane under pressure to assure uniformity, the desired impedance, and the proper attenuation.

The backing block 10 has a distal or top surface 12 to which a piezoelectric transducer array attaches. The backing block 10 has a rear or bottom surface 14 from which a flexible circuit board 20 extends. The flex circuit 20 is formed of a sheet 28 of flexible nonconductive material such as Kapton. Formed on the sheet 28 by etching or photolithography is a series of conductive traces 22 formed of, for example, copper. The conductive traces are formed with a lateral spacing which matches the pitch of the elements of the transducer array. The distal ends 24 of the conductive traces are flush with the distal surface 12 of the backing block, where they will align and make electrical contact with the elements of an attached transducer array. At their proximal ends at the bottom of the backing block the conductive traces can be connected to electrical circuitry which interacts with the transducer elements, such as transducer drivers, receivers, tuning elements, or multiplexers.

In a preferred embodiment, the flexible sheet 28 does not extend to the surface 12 of the backing block alongside the conductive traces. Instead, the distal edge 26 of the sheet 28 terminates inside the backing block and short of the surface 12. This eliminates the possibility of contamination of the distal ends of the conductive traces with adhesives and particulate matter from the flexible sheet.

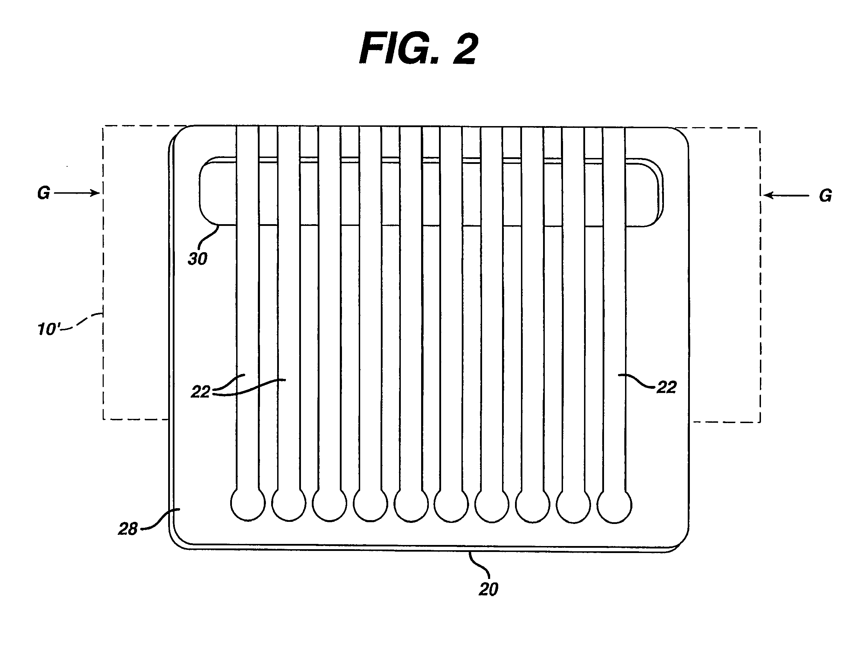

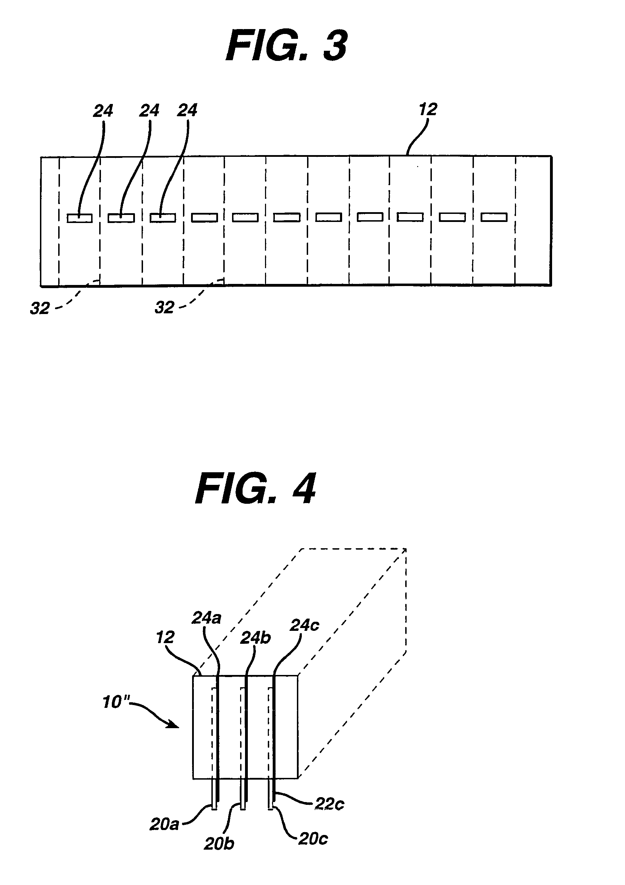

A plan view of the initial flex circuit 20 of a preferred embodiment of the present invention is shown in FIGURE 2. In this embodiment an aperture or window 30 has been etched through the flexible sheet 28 behind the conductive traces 30. The conductive traces remain fixed in their desired parallel orientation and spacing, which matches the array pitch, since the traces remain attached to the sheet 28 on either side where they bridge the window 30. To form the backing block of FIGURE 1, the backing material is cast around the flex circuit 20 as indicated by the outline 10'. After the backing material has cured, the distal end of the block is ground and lapped down to the level indicated by opposing arrows G, with reference to tooling fixtures on the block (not shown). This process removes the portion of the sheet 28 above the window 30, leaving the distal ends of the traces 22 flush with the finished distal end of the block and "flying", that is, with no adjacent flex board material. FIGURE 3 is a plan view of the distal surface 12 of the finished backing block, with the distal ends 24 of the conductive traces 22 shown in alignment between the locations 32 of the kerfs of the transducer array elements.

This inventive technique for forming a transducer backing block with precisely aligned conductors is readily suited for use with a two dimensional array of transducer elements as shown by the end view of the backing block 10'' of FIGURE 4. As there shown, three flex circuits 20a, 20b, and 20c are embedded in the backing material of the block. Three rows of the ends of separate conductive traces 24a, 24b, and 24c are thus formed at the distal surface 12 of the block. This embodiment will provide separate electrical connections to an attached transducer array of three rows of transducer elements along the length of the block.

It will be understood that, while the above embodiments are illustrated with ten conductive traces, a constructed embodiment will have 128 or more conductive traces for transducer of 128 or more elements in a row.

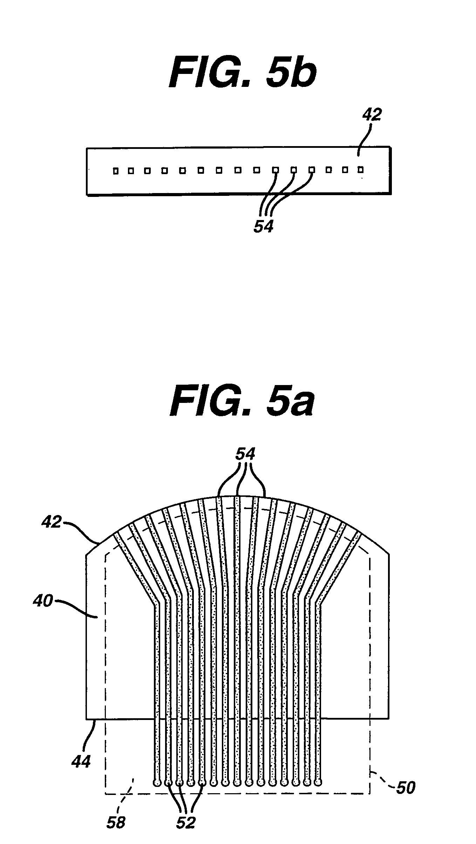

FIGURES 5a and 5b illustrate a preferred embodiment of the present invention. In this embodiment a flex circuit 50 has its conductive traces 52 arranged on the Kapton sheet 58 in a fanning pattern which that the distal ends 54 of the traces are evenly distributed along the arcuate distal surface 42 of the backing block 40, as shown in the top view of the surface 42 in FIGURE 5b. The arcuate distal surface is formed by cylindrically grinding this surface to the desired radius of curvature. As before, the proximal end of the flex circuit 50 extends from the proximal end 44 of the backing block 40 for attachment to other circuitry.

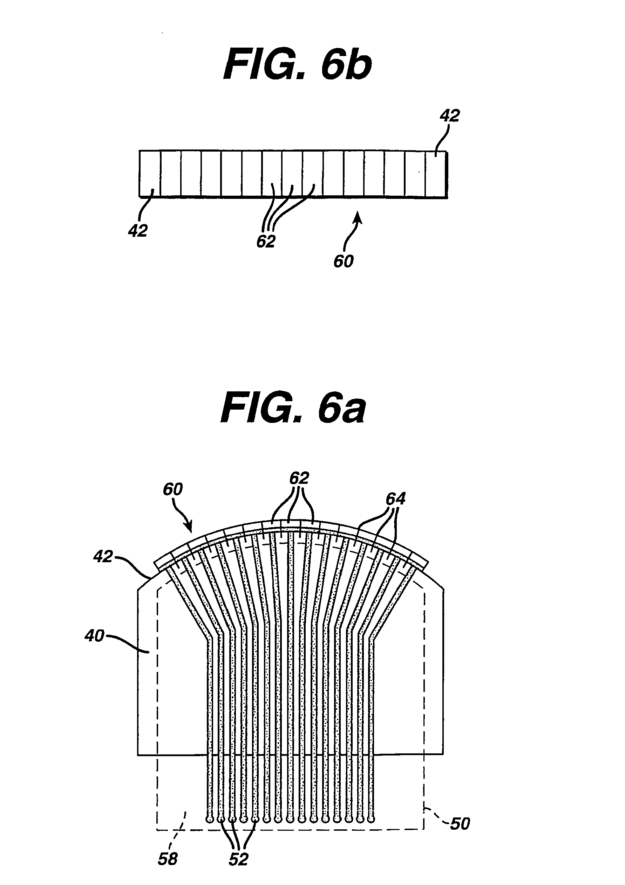

In FIGURE 6a, a curved transducer array 60 is adhesively attached to the distal surface 42 of the block 40, with individual transducer elements 62 aligned with the distal ends of the conductive traces. The kerfs between the transducer elements 62 are indicated at 64. FIGURE 6b is a top plan view of the assembly shown with the transducer array 60 attached in place. The conventional way to prepare the transducer array is to cut a bar of piezoelectric ceramic to the desired dimensions of the array, attach the bar to a flexible backing, then dice the individual elements of the array. Once the bar has been cut into separate elements, the array can be curved on a mandrel to the desired arc of curvature and then affixed to the backing 40.

In accordance with the principles of a further aspect of the present invention, the transducer array is formed of a composite piezoelectric material. A composite transducer is formed by subdicing a bar of piezoelectric material into many fine subelements, then filling in the kerfs between the subelements with a kerf filler such as an epoxy or urethane. Rather than exhibit the properties of unitary elements of piezoelectric, the composite transducer will exhibit the properties of the subelements in the aggregate. This allows a designer to control characteristics of the transducer such as the acoustic impedance. And formed as it is of a matrix of piezoelectric subelements and filler, the composite transducer can be conformed to the desired arcuate shape before it has been diced into individual transducer elements.

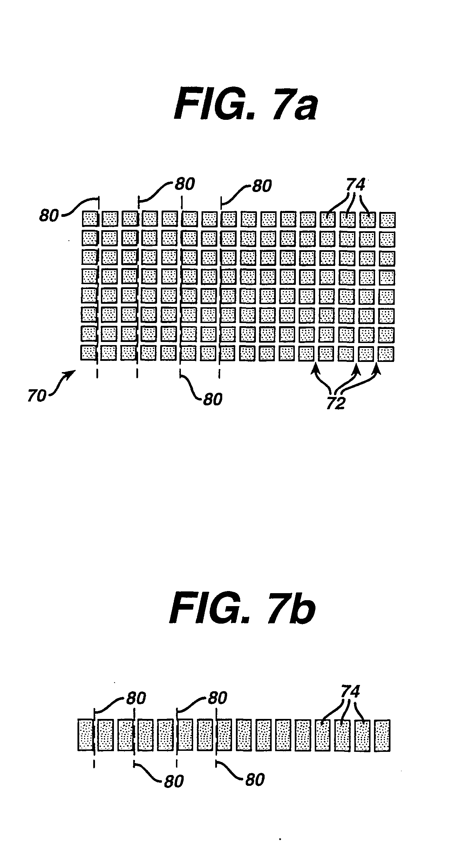

A portion of a typical composite transducer array 70 is shown in top plan and side views in FIGURES 7a and 7b. A bar of piezoelectric ceramic has been subdiced into many small subelements or pillars 74. The interstices 72 between the pillars 74 are filled with an epoxy filler. The illustrated composite material is termed a 1-3 composite, where "1" indicates the number of directions in which the piezoelectric is continuous from one boundary of the transducer to another (the direction being from the top to the bottom of the pillars 74 in FIGURE 7b), and "3" indicates the number of directions in which the filler material is continuous from one boundary of the transducer to another (the directions being horizontally and vertically in FIGURE 7 and vertically in FIGURE 7b). The composite bar is then diced into individual transducer elements along the cut lines 80.

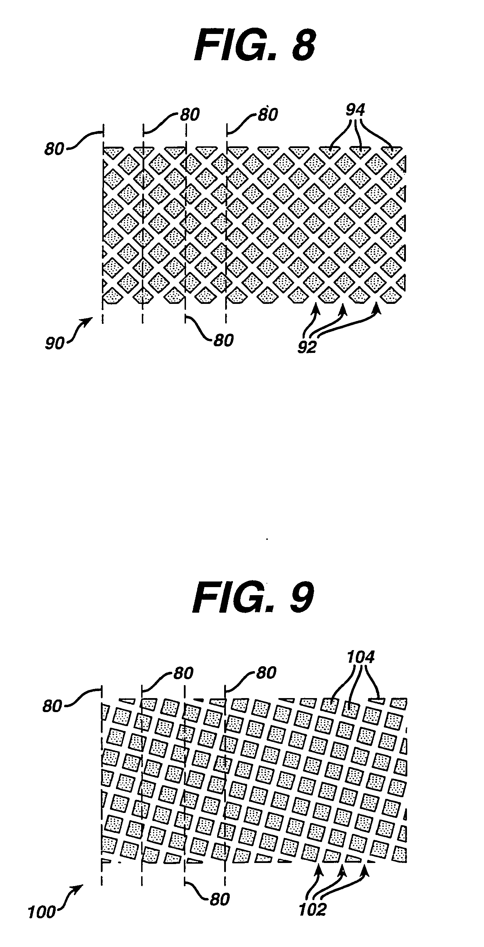

However, the present inventor has noted that it is difficult to maintain a uniform element pitch along the length (horizontally in the drawings) of the array 70 while maintaining the dicing cuts or kerfs 80 in registration with the interstices 72 of the composite, as shown in the drawings. In part this is due to the fact that most filler materials are known to shrink during curing, changing the dimensions of the bar. In accordance with a further aspect of the present invention, the present inventor orients the composite material pattern at a non-parallel, non-orthogonal orientation to the array kerfs as shown in FIGURES 8 and 9. The bars of composite material shown in these drawings are formed by subdicing a plate of piezoelectric material and filling the interstices thus formed, then cutting out the bar of array composite from the composite plate at the desired angle to the composite pattern. In FIGURE 8 the element dicing cuts 80 of transducer array 90 are at a 45° angle to the pattern of the rows of pillars 94 and filler interstices 92, and in FIGURE 9 the element dicing cuts 80 of transducer array 100 are at a 15° angle to the pattern of the rows of pillars 104 and filler interstices 102. The oblique orientation of the pattern of the composite material and the kerfs provides a performance advantage, in that the modes of lateral resonance of the array elements are no longer aligned with those of the subelements. Thus, the lateral propagation of lamb waves and lateral resonances which cause ringing in elements of the array is strongly suppressed by this oblique orientation of the array elements and composite pattern.

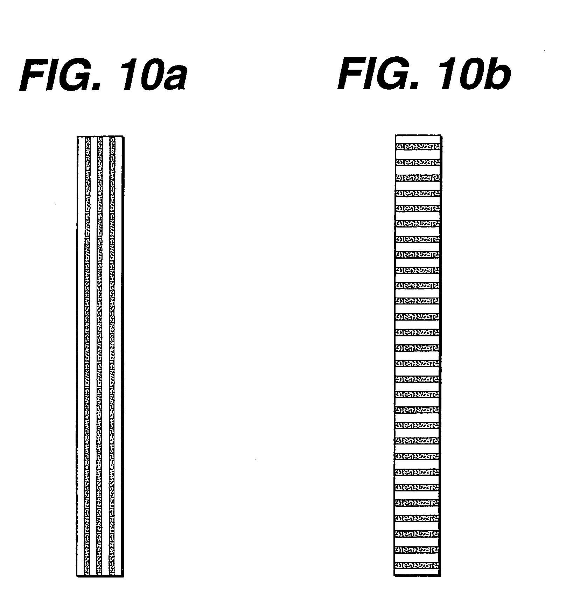

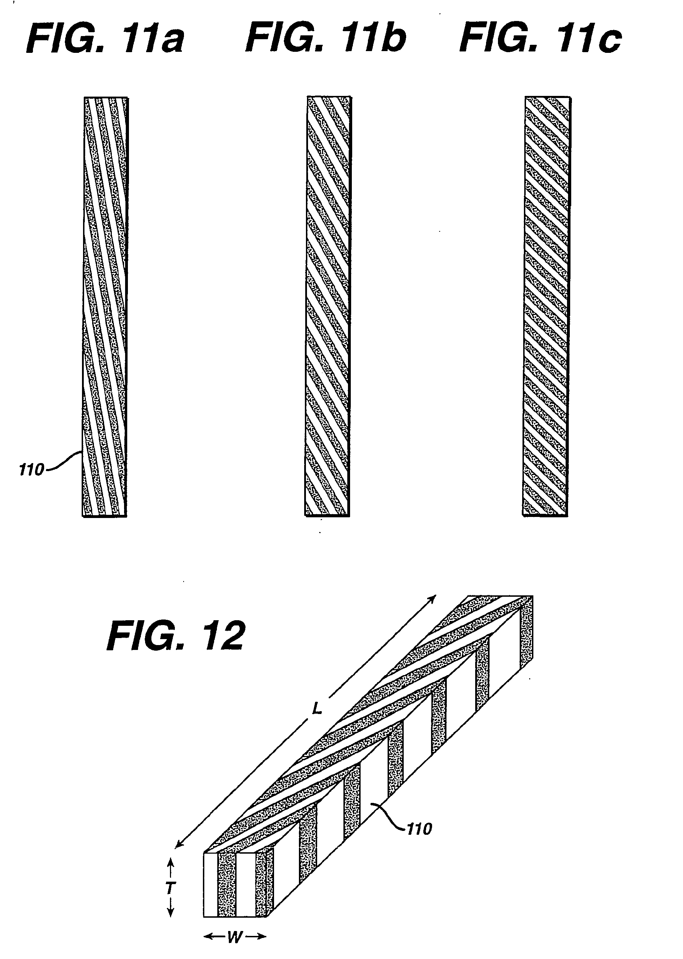

FIGURES 10a-12 illustrate this oblique orientation for 2-2 composite transducer elements, in which each drawing depicts a single element of a composite transducer array. In these drawings, the shaded stripes represent composite filler and the white stripes represent piezoelectric material. In FIGURES 10a and 10b the pattern of the 2-2 composite is at the conventional 0° and 90° angles to the kerf cuts, which in these drawings are the vertical sides of the elements. In FIGURE 11a the composite pattern of the element 110 is at a 10° angle to the side kerfs, in FIGURE 11b the angle is 25°, and in FIGURE 11c the angle between the composite pattern and the sides of the element is 45°. Arrays with shallower angles have been found most easy to conform for a curved transducer array. The element 110 of FIGURE 11a is shown in a perspective view in FIGURE 12, where L is the width of the element along the kerf cut, T is the thickness of the element, and W is the width of the element. The composite element provides another benefit which is apparent in this drawing.
It is seen in FIGURE 12 that the width W and thickness T of the element have approximately the same dimension. If this were a conventional entirely ceramic piezoelectric element, the resonance modes in the T and W directions would be approximately the same due to the similarity of these dimensions. Since the element is intended to have a dominant resonance in the T direction, the direction of ultrasound transmission, the element would have to be subdiced to increase its lateral resonant frequency. The subdicing cut would result in two subelements, each with a dimension of L, T, and slightly less than W/2 in the width dimension. However, such subdicing is not necessary for the element shown in FIGURE 12, as each piezoelectric subelement of the composite, in combination with the selected subelement angle of the composite, already exhibits the preferred height T to width W ratio. That is, the T dimension of each composite piezoelectric subelement is already in excess of its W dimension. Since the elements of the array do not need to be subdiced, the resulting array is more rugged and less expensive to fabricate than a comparable subdiced array.

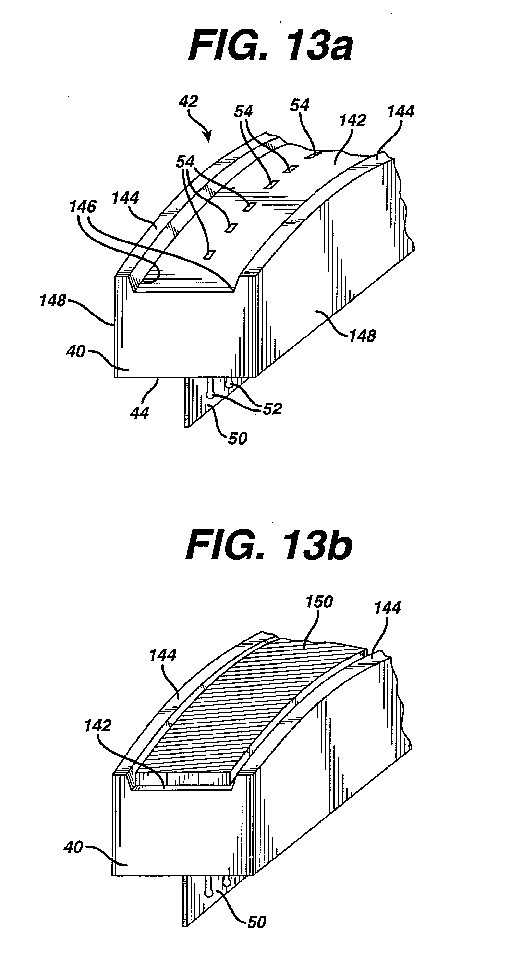

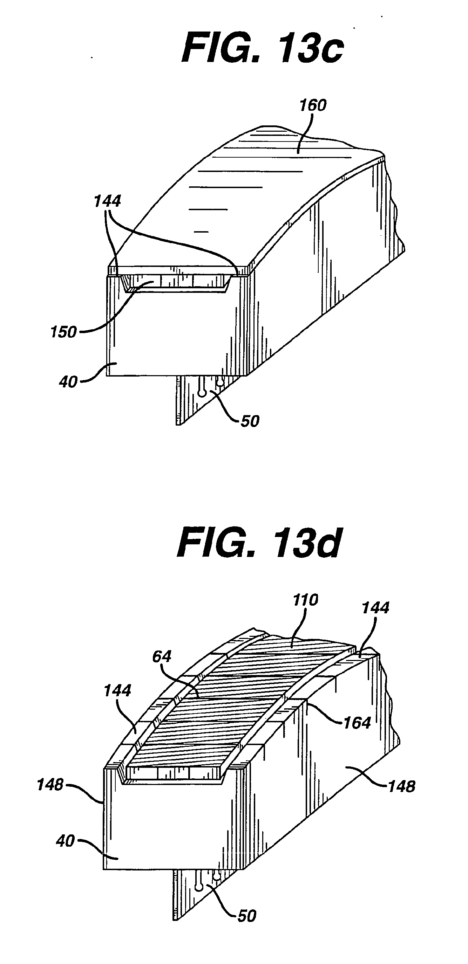

FIGURES 13a-13d illustrate different stages of construction of a convex array in accordance with the principles of the present invention. FIGURE 13a illustrates a backing block 40 in which a flex circuit 50 has been embedded. The proximal end of the flex circuit is seen extending from the proximal end 44 of the block 40. Conductive traces 52 of the flex circuit terminate at distal ends 54 on the distal surface 42 of the block 40. The distal surface has been ground and lapped to form a central floor surface 142 with which the distal ends 54 of the conductive traces are aligned. The floor surface 142 is bounded on either side by a shoulder 144. The block 40 is prepared for the transducer array by coating the floor surface 142, the shoulders 144, and the lateral sides 148 of the block with a metallic adhesion layer and then a gold coating. The adhesion layer and gold coating are then scored at the junctures 146 of the shoulders with the floor surface to electrically isolate the floor surface from the gold coating on the shoulders 144 and lateral sides 148. The distal ends 54 of the conductive traces are in electrical contact with the gold coating on the floor surface 142.

A composite array transducer is prepared, coated with gold on both its top (emitting and receiving) side and bottom (floor surface facing) side, and conformed to the shape of the convex arc of the floor surface 144. In FIGURE 13b the transducer array 150 comprises a 2-2 composite with a 10° orientation between the pattern of the composite material and the kerf locations (see FIGURES 11a and 12). The composite array bar 150 is readily conformed to the intended convex arc.

The gold coated surfaces of the composite array bar 150 are lightly coated with a low viscosity adhesive and the bar 150 is then set on the floor surface 142 of the backing block 40 as shown in FIGURE 13b. The ends of the bar 150 which oppose the side shoulders 144 are not in contact with either of the adjacent shoulders 144. An acoustic matching layer sheet 160 is then placed across the top surface of the array and the shoulders 144 as shown in FIGURE 13c. The characteristics of the sheet 160 are chosen to provide the desired acoustic impedance matching. Kapton has been found to be one suitable material for sheet 160. The side of the sheet 160 is coated with gold and makes contact with the adhesively coated, gold coated top surface of the transducer array 150. Pressure is then applied to the backing block 40 and the sheet 160 to compress the adhesively coated array 150 between the floor surface and the matching layer sheet 160, thereby squeezing excess adhesive from between the gold coated surfaces and achieving electrical contact between the gold surfaces. The sides of the sheet 160 are also adhesively attached to the top surfaces of the shoulders 144. The adhesive is then allowed to cure.

The transducer array bar 150 is diced into separate transducer array elements 110 by cutting through the matching layer sheet 160, transducer bar 150, and the surrounding shoulders 144, as shown in FIGURE 13d. In this drawing the matching layer sheet 160 is not shown so that the diced array elements 110 can be clearly seen. The dicing cuts 64 extend through the gold coating on the floor surface 142 to separate the coating into separate electrical areas for each element 110 and its conductive trace 52,54. The dicing cuts also extend through the shoulders 144 as shown at 164. However, the tops of the transducer elements are all electrically connected to the gold coating on the underside of the matching layer sheet 160, which in turn is electrically connected to the gold coating on the tops of the shoulders 144 and to the gold coating on the sides 148 of the block 40. Thus, a ground potential can be applied to the top surfaces of all of the transducer elements 110 by connecting a ground lead to the sides 148 of the backing block 40, while the bottom surface of each transducer element 110 is connected to its own conductive trace 52 for the application of excitation potentials and reception of echo signals.

## Claims

1. A monolithic backing block (10) for subsequent attachment to an ultrasonic array transducer comprising:
a body of acoustic backing material,
a flexible circuit board (20) having a plurality of conductive traces (22) formed thereon in a pattern corresponding to a predetermined array element spacing, said flexible circuit board being embedded in the body of acoustic backing material,
said conductive traces extending to a distal, array contacting side of said body at which said traces are fixed and aligned for making electrical connection with array elements of the ultrasonic array transducer at the surface of said array transducer which is adapted to be attached to said body, and
said conductive traces extending out from a second, proximal side of said body for connection to electrical circuitry.

2. The backing block of Claim 1, wherein said flexible circuit board extends substantially orthogonally from said distal side of said body.

3. The backing block of Claim 1, wherein said conductive traces extend to electrical connection points on said flexible circuit board outside of said body.

4. The backing block of Claim 1, further including at least one additional flexible circuit board having a plurality of conductive traces formed thereon and embedded in said body of acoustic backing material.

5. The backing block of Claim 1, wherein said distal, array contacting side of said body is convexly curved.

6. The backing block of Claim 1, wherein said distal, array contacting side is coated with a conductive electrode material.

7. The backing block of Claim 6, wherein said conductive electrode material is separated into individual electrodes at the time of dicing of the transducer array.

8. The backing block of Claim 6, wherein said distal side is formed into a central depression with opposing shoulders into which depression said array transducer is mounted.

9. The backing block of Claim 8, wherein said shoulders are connected to a reference potential.

10. The backing block of Claim 9, further comprising a matching layer, extending across said shoulders and having a reference electrode surface contacting the patient facing surface of said transducer array.

11. A method of manufacturing a monolithic backing block (10) adapted to be subsequently attached to an ultrasonic array transducer, said method comprising in series the steps of:
forming on a flexible circuit board (20) a plurality of conductive traces (22) in a pattern corresponding to a predetermined array element spacing,
casting a body of acoustic backing material around said flexible circuit board, such that said conductive traces extends to a distal, array contacting side of said body at which said traces are fixed and aligned for making electrical connection with array elements of the ultrasonic array transducer at the surface of said array transducer which is adapted to be attached to said body, and that said conductive traces extends out from a second, proximal side of said body for connection to electrical circuitry,
curing the backing material.

## Patentansprüche

1. Monolithischer Unterstützungsblock (10) zum anschließenden Anbringen an einem Ultraschall-Arraywandler mit:
einem Körper aus akustischem Unterstützungsmaterial,
einer flexiblen Leiterplatte (20) mit einer Vielzahl von Leiterbahnen (22), die darauf in einem Muster gebildet sind, das einem vorgegebenen Array-Element-Abstand entspricht, wobei die genannte flexible Leiterplatte in den Körper aus akustischem Unterstützungsmaterial eingebettet ist,
wobei die genannten Leiterbahnen zu einer distalen, mit dem Array in Kontakt befindlichen Seite des genannten Körpers verlaufen, an der die genannten Leiterbahnen fixiert und so ausgerichtet sind, dass sie eine elektrische Verbindung mit Array-Elementen des Ultraschall-Arraywandlers an der Oberfläche des genannten Arraywandlers herstellen, der dafür eingerichtet ist, an dem genannten Körper angebracht zu werden, und
wobei die Leiterbahnen aus einer zweiten, proximalen Seite des genannten Körpers herausragen, um eine Verbindung zu elektrischen Schaltungen herzustellen.

2. Unterstützungsblock nach Anspruch 1, wobei die genannte flexible Leiterplatte im Wesentlichen orthogonal zu der genannten distalen Seite des genannten Körpers verläuft.

3. Unterstützungsblock nach Anspruch 1, wobei die genannten Leiterbahnen zu elektrischen Verbindungspunkten auf der genannten flexiblen Leiterplatte außerhalb des genannten Körpers verlaufen.

4. Unterstützungsblock nach Anspruch 1, weiterhin mit mindestens einer zusätzlichen flexiblen Leiterplatte mit einer Vielzahl von darauf gebildeten Leiterbahnen und eingebettet in den genannten Körper aus akustischem Unterstützungsmaterial.

5. Unterstützungsblock nach Anspruch 1, wobei die genannte distale, mit dem Array in Kontakt befindliche Seite des genannten Körpers konvex gebogen ist.

6. Unterstützungsblock nach Anspruch 1, wobei die genannte distale, mit dem Array in Kontakt befindliche Seite mit einem leitenden Elektrodenmaterial beschichtet ist.

7. Unterstützungsblock nach Anspruch 6, wobei das genannte leitende Elektrodenmaterial beim Unterteilen des Wandlerarrays in einzelne Elektroden geteilt wird.

8. Unterstützungsblock nach Anspruch 6, wobei die genannte distale Seite in einer zentralen Vertiefung mit einander gegenüberliegenden Schultern gebildet wird, in der der genannte Arraywandler montiert wird.

9. Unterstützungsblock nach Anspruch 8, wobei die genannten Schultern mit einem Bezugspotenzial verbunden sind.

10. Unterstützungsblock nach Anspruch 9, weiterhin mit einer passenden Lage, die quer über die genannten Schulter verläuft und eine Bezugselektrodenoberfläche hat, die in Kontakt mit der dem Patienten zugewandten Oberfläche des genannten Wandlerarrays steht.

11. Verfahren zur Herstellung eines monolithischen Unterstützungsblocks (10), der dafür eingerichtet ist, anschließend an einem Ultraschall-Arraywandler angebracht zu werden, wobei das genannte Verfahren nacheinander die folgenden Schritte umfasst:
Bilden einer Vielzahl von Leiterbahnen (22) auf einer flexiblen Leiterplatte (20) in einem Muster, das einem vorgegebenen Array-Element-Abstand entspricht,
Gießen eines Körpers aus akustischem Unterstützungsmaterial um die genannte flexible Leiterplatte, so dass die genannten Leiterbahnen zu einer distalen, mit dem Array in Kontakt befindlichen Seite des genannten Körpers verlaufen, an der die genannten Leiterbahnen fixiert und so ausgerichtet werden, dass sie eine elektrische Verbindung mit Array-Elementen des Ultraschall-Arraywanlders an der Oberfläche des genannten Arraywandlers herstellen, der dafür eingerichtet ist, an dem genannten Körper angebracht zu werden, und dass die genannten Leiterbahnen aus einer zweiten, proximalen Seite des genannten Körpers herausragen, um eine Verbindung zu elektrischen Schaltungen herzustellen,
Aushärten des Unterstützungsmaterials.

## Revendications

1. Bloc arrière monolithique (10) destiné à être ultérieurement attaché à un ensemble transducteur ultrasonique, comprenant:
un corps en matériau acoustique de support,
une carte à circuit imprimé flexible (20) comportant une pluralité de traces conductrices (22) formées sur cette carte en un motif correspondant à un espacement prédéterminé des éléments de l'ensemble transducteur, ladite carte à circuit imprimé flexible étant incorporée dans le corps de matériau acoustique de support,
lesdites traces conductrices s'étendant jusqu'à un côté distal de contact avec l'ensemble dudit corps au niveau duquel lesdites traces sont fixées et alignées pour établir des connexions électriques avec des éléments de l'ensemble transducteur ultrasonique au niveau de la surface dudit ensemble transducteur qui est destinée à être attachée audit corps, et
lesdites traces conductrices s'étendent vers l'extérieur à partir d'un second côté proximal dudit corps en vue d'une connexion au circuit électrique.

2. Bloc arrière suivant la revendication 1, dans lequel ladite carte à circuit imprimé flexible s'étend pratiquement perpendiculairement à partir dudit côté distal dudit corps.

3. Bloc arrière suivant la revendication 1, dans lequel lesdites traces conductrices s'étendent jusqu'à des points de connexion électrique sur ladite carte à circuit imprimé flexible à l'extérieur dudit corps.

4. Bloc arrière suivant la revendication 1, comprenant en outre au moins une carte à circuit imprimé flexible supplémentaire comportant une pluralité de traces conductrices formées sur cette carte et incorporées dans ledit corps de matériau acoustique de support.

5. Bloc arrière suivant la revendication 1, dans lequel ledit côté distal du corps de contact avec l'ensemble transducteur est courbé de façon convexe.

6. Bloc arrière suivant la revendication 1, dans lequel ledit côté distal de contact avec l'ensemble transducteur est revêtu d'un matériau d'électrode conducteur.

7. Bloc arrière suivant la revendication 6, dans lequel ledit matériau d'électrode conducteur est séparé en électrodes individuelles au moment de la coupe de l'ensemble transducteur en éléments.

8. Bloc arrière suivant la revendication 6, dans lequel ledit côté distal est façonné en un creux central présentant des épaulements opposés, ledit ensemble transducteur étant monté dans ledit creux.

9. Bloc arrière suivant la revendication 8, dans lequel lesdits épaulements sont connectés à un potentiel de référence.

10. Bloc arrière suivant la revendication 9, comprenant en outre une couche d'adaptation qui s'étend en travers desdits épaulements et qui comporte une surface d'électrode de référence en contact avec la surface dudit ensemble transducteur tournée vers le patient.

11. Procédé de fabrication d'un bloc arrière monolithique (10) propre à être ultérieurement attaché à un ensemble transducteur ultrasonique, ledit procédé comprenant en série les étapes suivantes:
formation sur une carte à circuit imprimé flexible (20) d'une pluralité de traces conductrices (22) en un motif correspondant à un espacement prédéterminé des éléments de l'ensemble transducteur,
coulée d'un corps de matériau acoustique de support arrière autour de ladite carte à circuit imprimé flexible, de telle sorte que les traces conductrices s'étendent jusqu'à un côté distal de contact avec l'ensemble dudit corps au niveau duquel lesdites traces sont fixées et alignées pour établir des connexions électriques avec des éléments de l'ensemble transducteur ultrasonique au niveau de la surface dudit ensemble transducteur qui est destinée à être attachée audit corps, et que lesdites traces conductrices s'étendent vers l'extérieur à partir d'un second côté proximal dudit corps pour connexion au circuit électrique,
durcissement de la matière de support arrière.
